(19) Europäisches Patentamt
European Patent Office
Office européen des brevets

(11) **EP 1 850 402 B1**

(12) **EUROPÄISCHE PATENTSCHRIFT**

(45) Veröffentlichungstag und Bekanntmachung des Hinweises auf die Patenterteilung:
**29.07.2009 Patentblatt 2009/31**

(51) Int Cl.:
**H01L 39/24** *(2006.01)*

(21) Anmeldenummer: **07005968.8**

(22) Anmeldetag: **22.03.2007**

(54) **Naß-chemisches Verfahren zur Herstellung eines HTSL**

Wet chemical method for manufacturing an HTSC

Procédé de chimie humide destiné à la fabrication d'un supraconducteur à haute température (HTSL)

(84) Benannte Vertragsstaaten:
**AT BE BG CH CY CZ DE DK EE ES FI FR GB GR HU IE IS IT LI LT LU LV MC MT NL PL PT RO SE SI SK TR**

(30) Priorität: **20.04.2006 DE 102006018301**

(43) Veröffentlichungstag der Anmeldung:
**31.10.2007 Patentblatt 2007/44**

(73) Patentinhaber: **Zenergy Power GmbH**
**53359 Rheinbach (DE)**

(72) Erfinder: **Bäcker, Michael, Dr.**
**50670 Köln (DE)**

(74) Vertreter: **Prietsch, Reiner**
**Dipl.-Ing. Reiner Prietsch**
**Patentanwalt**
**Postfach 11 19**
**82141 Planegg (DE)**

(56) Entgegenhaltungen:
WO-A-01/99123          WO-A-20/06137898
DE-A1- 4 116 094       US-A1- 2005 159 298

• AGRANOVSKI I E ET AL: "Methods of introduction of MgO nanoparticles into Bi-2212/Ag tapes" PHYSICA C ELSEVIER NETHERLANDS, Bd. 434, Nr. 1, 1. Februar 2006 (2006-02-01), Seiten 115-120, XP002477323 ISSN: 0921-4534

**Beschreibung**

Die Erfindung betrifft einen naß-chemisch hergestellten, bandförmigen Hochtemperatursupraleiter (HTSL) mit einem Träger, auf dem eine HTSL-Schicht mit Pinningzentren ist, und ein Herstellungsverfahren hierfür.

Aus der US 2005/01 59 29 8 A1 ist bekannt, dass die kritische Stromdichte bzw. die kritische magnetische Flußdichte eines HTSL durch sogenannte Pinningzentren erhöht wird. Diese Erhöhung resultiert aus einer räumlichen Fixierung der den stromdurchflossenen HTSL orthogonal zur Stromflußrichtung durchsetzenden, magnetischen Flußschläuche durch die Pinningzentren. Eine solche Fixierung wird durch jede Störung des gleichmäßigen Kristallgefüges des HTSL erreicht, d.h. durch einen Bruch der Translationssymmetrie des Gitters. Somit ist jede Störung der Gittersymmetrie ein Pinningzentrum. Als Störungen wirken beispielsweise sogenannte Nanopartikel, d.h. Teilchen mit einem Durchmesser zwischen etwa 1 nm und etwa 200 nm oder auch atomare Störstellen.

Zur Herstellung eines HTSL mit Pinningzentren wird die Precursorlösung gezielt dotiert, beispielsweise durch Zugabe von in der Precursorlösung nicht löslichen Nanopartikeln. Alternativ oder zusätzlich können auch lösliche Stoffe, beispielsweise Metallsalze zugegeben werden. Die Metalle verursachen im späteren HTSL Gitterfehler. Nachfolgend wird der Begriff "Pinningzentrum" auch für Zusätze zur Precursorlösung benutzt, die im späteren HTSL Gitterfehlstellen verursachen, welche die magnetischen Flußschläuche fixieren können.

Die nicht vorveröffentlichte WO 2006/137898 A2 beschreibt ein Verfahren, bei dem mehrere sog. YBCO (YBa$_2$Cu$_3$O$_{7-x}$)-Schichten übereinander auf einen Träger aufgebracht werden. Die Schichten können Pinningzentren aufweisen. Die Pinningzentren entstehen, weil eine YBCO-Precursorlösung mit einem Kupferüberschuss oder alternativ einem Bariummangel verwendet wird. Die Pinningzentren können in allen, keiner oder einer beliebigen Anzahl der Schichten sein.

Bei der naß-chemischen Herstellung von HTSL mit Pinningzentren behindern die Pinningzentren ein texturiertes Aufwachsen der HTSL-Schicht auf dem texturierten Träger. Dies führt zu einer Verringerung der kritischen Stromdichte.

Der Erfindung liegt die Aufgabe zugrunde, ein naß-chemisches Verfahren zur Herstellung eines HTSL mit hoher kritischer Stromdichte bereit zu stellen.

Diese Aufgabe wird durch ein Verfahren nach einem der unabhängigen Ansprüch gelöst.

Zur Herstellung eines bandförmigen HTSL gemäß dem im Anspruch 1 angegebenen Verfahren werden auf einen Träger nacheinander mehrere HTSL-Schichten aufgebracht. Der Träger kann ein Metallsubstrat, vorzugsweise mit Pufferschicht, oder ein Keramikmaterial, das auch als Pufferschicht verwendbar ist, sein. Die Pufferschicht soll eine texturierte Abscheidung des HTSL auf dem Träger gewährleisten. Der HTSL kann ein beliebiger naß-chemischer abscheidbarer Typ II-Supraleiter sein. Zur Herstellung eines solchen HTSL wird auf den Träger eine Precursorlösung aufgebracht. Anschließend wird die Lösung getrocknet, dann mittels einer Glühbehandlung die HTSL-Schicht erzeugt. Die Glühbehandlung umfasst in der Regel einen Pyrolyse und anschließend einen Sinterschritt. Pinningzentren lassen sich in den HTSL einbringen, in dem man der Precursorlösung entsprechende Substanzen hinzufügt. Dies können lösliche Metallsalze, ein Überschuß eines Metalls in der Precursorlösung oder auch unlösliche Nanopartikel sein. Im letzteren Fall ist die Precursorlösung eine Suspension.

Alternative Formen des erfindungsgemäßen Verfahrens werden durch die Ansprüche 2 bis 7 angegeben.

Der Kern der Erfindung besteht darin, dass die als erstes auf den Träger aufgebrachte Precursorlösung nur eine geringe Konzentration an Pinningzentren hat und dass die anschließend aufgebrachte Precursorlösung eine höhere Konzentration an Pinningzentren als die zu erst aufgebrachte Lösung hat. Insbesondere kann die als erstes verwendete Precursorlösung frei oder fast frei von Pinningzentren sein und die als zweites verwendete Precursorlösung Pinningzentren enthalten. Durch dieses Verfahren wird die Textur der Pufferschicht gut auf den HTSL übertragen. Dennoch hat der fertige HTSL Pinningzentren. Die Kombination aus hohem Texturierungsgrad und Pinningzentren ergibt einen HTSL mit gegenüber dem Stand der Technik erhöhter kritischer Stromdichte. Durch das Aufbringen weiterer Schichten kann die Stärke (Dicke) der HTSL-Schicht erhöht werden.

Wird auf die zweite Schicht eine dritte Schicht aufgebracht, so hat letztere vorzugsweise eine geringere Konzentration an Pinningzentren als die zweite Schicht.

Werden mehr als drei Schichten aufgetragen, so sind alternierende Konzentrationen bevorzugt.

Vorzugsweise werden Schichten mit einer geringen Konzentration an Pinningzentren dünner aufgetragen als Schichten mit einer höheren Konzentration.

Als Pinningzentren können insbesondere Nanopartikel mit einem mittleren Durchmesser kleiner 110nm verwendet werden.

Bevorzugt haben die Nanopartikel einen mittleren maximalen Durchmesser (Korngröße) zwischen etwa 2 nm und etwa 80 nm, besonders bevorzugt zwischen etwa 5 nm und etwa 60 nm.

Die Nanopartikel sind gegenüber dem HTSL und seinen Edukten vorzugsweise weitgehend inert.

Vorzugsweise sind die Gittervektoren der Nanopartikel insbesondere betragsmäßig ähnlich zu den Gittervektoren der HTSL-Schicht. Z.B. kann die Länge eines Gittervektors der Nanopartikel ähnlich zur Länge eines Gittervektors des HTSL oder einem ganzzahligen Vielfachen davon sein. Besonders bevorzugt sind - sofern der HTSL ein Cuprat-SL ist - zwei der Gittervektoren der verwendeten Nanopartikel in Länge und/oder Winkel ähnlich zu den Gittervektoren der CuO-Ebene des Cuprat-SL. Beispielsweise können Länge und Winkel der entsprechenden Vektoren um weniger als 10% von einander abweichen. Dadurch "heilt" der durch ein Nanopartikel verursachte Gitterdefekt in der Nähe des Nanopartikels auf kurzer Distanz aus, wodurch sich das effektive supraleitende Volumen des HTSL erhöht.

Zur Erzeugung von HTSL-Schichten mit Pinningzentren können Precursorlösungen verwendet werden, die Zirkonoxid, stabilisiertes Zirkonoxid, Ceroxid, Bariumzirkonat, Lathanzirkonat oder Yttriumoxid enthalten. Ebenso kann auch $RE_2Ba_4CaMO_y$ verwendet werden, wobei RE für beliebige seltene Erdmetalle, M für Zr, Nb, Mo, Ru, Hf, Ta, W oder Sn und y für eine rationale Zahl größer 0 stehen.

Ein nach der Erfindung hergestellter HTSL besteht aus einem Träger, auf dem eine HTSL-Schicht naß-chemisch aufgebracht wurde, beispielsweise in einem Verfahren nach dem Anspruch 1. Bei dem HTSL nimmt die Konzentration der Pinningzentren in der HTSL-Schicht zumindest in Richtung des Trägers ab. Dadurch wird der Texturübertrag von dem Träger auf die HTSL-Schicht nur minimal gestört, d.h. der fertige HTSL hat mit Ausnahme der Bereiche um die Pinningzentren ein nahezu perfektes Kristallgitter, was zu einer hohen kritischen Stromdichte führt.

In einer bevorzugten Ausführungsform ist die Grenzfläche zwischen der HTSL-Schicht und dem Träger frei von Pinningzentren. Beispielsweise kann die HTSL-Schicht im Bereich zwischen dem Träger und den ersten etwa 100nm frei von Pinningzentren sein.

Vorzugsweise beträgt das Volumen nanoskaliger Pinningzentren in der HTSL-Schicht zwischen etwa 5 % und etwa 25 %, besonders bevorzugt zwischen etwa 10 % und etwa 20 % des Gesamtvolumens der HTSL-Schicht.

Die Erfindung wird anhand der Beispiele 1 und 2 näher erläutert:

Beispiel 1

Y(III)-Acetat-Tetrahydrat (Y(OOCCH3)·4H2O: Alfa Aesar, 99,99 % (REO), kristallin) und Cu(II)-Acetat-Monohydrat (Cu(OOCCH3)2·H2O: Aldrich, ≥ 99,99 %, kristallin) werden in Wasser gelöst. Nach Zugabe von Ethanol (CH3CH2OH: Merck, zur Synthese, ≥ 99 %, Schmelzpunkt: -114,5°C, Siedepunkt: 78,3°C, Flammpunkt: 12°C) und Pivalinsäure (Trimethylessigsäure: (CH3)3CCOOH: Merck, zur Synthese, > 98 %, Schmelzpunkt: 32-35°C, Siedepunkt: 164°C, Flammpunkt: 64°C, Löslichkeit in H2O: 25g/l (25°C)) wird die erhaltene Lösung im Trockenschrank getrocknet. Das entstehende Gemenge aus Y(III)- und Cu(II)-trimethylacetat wird mit Bariumhydroxid-Octahydrat (Ba(OH)2·8 H2O: Merck, zur Analyse, ≥ 98 %, Schmelzpunkt: 78°C) vermengt. Durch Zusatz von Propionsäure (Methylessigsäure, CH3CH2COOH: Merck, zur Synthese, ≥ 99%, Schmelzpunkt: -21°C, Siedepunkt: 141°C, Flammpunkt: 50°C), Propylamin (1-Aminopropan, CH3CH2CH2NH2: Merck, zur Synthese, > 99 %, Schmelzpunkt: -83°C, Siedepunkt: 48-50°C, Flammpunkt: -30°C), Methanol (CH3OH: Merck, zur Analyse, ACS, ISO, ≥ 99,8 %, Schmelzpunkt: -98°C, Siedepunkt: 64,5°C, Flammpunkt: 11°C) und Toluol (Methylbenzol, C6H5CH3: Merck, für die Spektroskopie, ≥ 99,9 %, Schmelzpunkt: -95°C, Siedepunkt: 110,6°C, Flammpunkt: 4°C) wird eine 0,1 molare kolloidale Lösung hergestellt. Die gewählte Konzentration bedingt eine geringe Endschichtdicke. Für die Erstbeschichtung sind Konzentrationen zwischen etwa 0,001M bis etwa 0,2M in Abhängigkeit von den weiteren Verfahrensparametern optimal. Strontiumtitanat-Substrate (Orientierung (100)) sowie mit Pufferschichten versehenes Metallband aus einer Legierung Ni mit 5 at% W wurden mit Hilfe des Dip-Coating Verfahrens beschichtet. Die Verweilzeit in der Lösung betrug maximal 15 s. Die Proben wurden mit einer Ziehgeschwindigkeit von 0,1 cm/s aus der Lösung herausgezogen. Die Ziehgeschwindigkeit kann in einem weiten Bereich von etwa 0,04 cm/s bis etwa 0,5 cm/s variieren, wobei eine niedrigere Ziehgeschwindigkeit eine geringere Schichtdicke und eine höhere Ziehgeschwindigkeit eine größere Schichtdicke bewirkt. Das Trocknen der Schicht erfolgte bei Temperaturen bis maximal 200°C im Trockenschrank. Die anschließende Pyrolyse wurde bei T ≤ 600°C in einem Kammerofen unter Luft durchgeführt.

Die Substrate mit der ersten pyrolysierten Schicht wurden anschließend in eine YBCO-TFA-Precursorsuspension mit unterschiedlichen Gehalten an verschiedenen Nanopartikeln mit einer Verweilzeit von maximal 15 s und einer Ziehgeschwindigkeit von 0,1 cm/s getaucht. Die YBCO-TFA-Precursorsuspensionen wurden aus Y(III)-acetat-Tetrahydrat (Y(OOCCH3)3·4 H2O: Alfa Aesar, 99,99 % (REO), kristallin), Ba(II)-acetat (Ba(OOCCH3)2: Alfa Aesar, 99,999 % (metals basis)) und Cu(II)-acetat-Monohydrat (Cu(OOCCH3)2·H2O: Aldrich, ≥ 99,99 %, kristallin) unter Verwendung von Trifluoressigsäure (CF3COOH: Merck, zur Synthese, > 99 %, Schmelzpunkt: -15°C, Siedepunkt: 72°C, umweltgefährlich!) und Methanol (CH3OH: Merck, zur Analyse, > 99,8 %, Schmelzpunkt: -98°C, Siedepunkt: 64,5°C, Flammpunkt: 11°C, giftig!) als Lösungsmittel hergestellt. Die Konzentration betrug 0,25M bezüglich Y. Die Zusammensetzungen der Lösungen wurden gemäß Y : Ba : Cu = 1 : 2 : 3 eingestellt:

Precursorsuspension 1:
1Gew% ZrO2 Partikel, mittlere Korngröße 55nm

Precursorsuspension 2:
5Gew% ZrO2 Partikel, mittlere Korngröße 55nm

Precusorsuspension 3:
2Gew% Y203 Partikel, mittlere Korngröße 40nm

Die erhaltenen Schichten wurden in feuchter Atmosphäre wärmebehandelt. Die Pyrolyse erfolgte bei $T \leq 400°C$ in $N_2$ / 2,5% $O_2$ - Atmosphäre. Die YBCO-Phasenbildung wurde unter einer Atmosphäre von $N_2$ / 100 ppm $O_2$ bei Maximaltemperaturen von 780 bis 790°C und mit einer Haltezeit zwischen einer halben und einer Stunde durchgeführt. Die Maximaltemperatur lag immer unterhalb der Schmelztemperatur des YBCO. Die Schmelztemperatur wiederum ist von der Sauerstoffkonzentration der Ofenatmosphäre abhängig. Bei höheren Sauerstoffgehalten bis zu 1% ist die Schmelztemperatur um ca. 10° erhöht, bei sauerstofffreier Atmosphäre um ca. 5° erniedrigt. Die Abkühlung der Proben erfolgte in $O_2$-Atmosphäre mit einer Haltezeit von 2 Stunden bei einer Temperatur zwischen 500 und 400°C. Typische Ergebnisse sind:

**Probe 1 (Precursorsuspension 1), Substrat STO:**

$$T_{C50} = 89,8 \text{ K}, \ \Delta T_C = 1 \text{ K}, \ J_C(resistiv) = 1,05 \text{ MA/cm}^2$$

Schichtdicke 1 (ohne Nanopartikel): $\approx$ 210 nm
Schichtdicke 2 (mit Nanopartikeln): $\approx$ 480 nm

$$Jc(5T)/Jc(0T) = 2,1$$

**Probe 2 (Precursorsuspension 2), Substrat STO:**

$$T_{C50} = 89,5 \text{ K}, \ \Delta T_C = 1,8 \text{ K}, \ J_C(resistiv) = 0,8 \text{ MA/cm}^2$$

Schichtdicke 1 (ohne Nanopartikel): $\approx$ 210 nm

Schichtdicke 2 (mit Nanopartikeln): $\approx$ 500 nm

$$Jc(5T)/Jc(0T) = 3,1$$

**Probe 3 (Precursorsuspension 1), Substrat STO:**

$$T_{C50} = 89,7 \text{ K}, \ \Delta T_C = 0,8 \text{ K}, \ J_C(resistiv) = 1,15 \text{ MA/cm}^2$$

Schichtdicke 1 (ohne Nanopartikel): $\approx$ 210 nm

Schichtdicke 2 (mit Nanopartikeln): $\approx$ 450 nm

$$Jc(5T)/Jc(0T) = 2,8$$

Beispiel 2

Auf ein texturiertes Metallband (Ni mit 5 at% W) wurde zunächst ein Pufferschichtsystem aufgebracht. Auch andere Nickellegierungen wie z.B. Ni mit0,1 % Mn können ohne Einfluss auf das Endergebnis dieses Beispiels verwendet werden.

Basis der Beschichtungslösung für eine erste Pufferschicht war Lanthan(III)- und Zirkonium(IV)-(2,4)pentandionat (Acetylacetonat) (Lanthan(III)-(2,4)pentandionat, La[CH$_3$COCH-COCH$_3$]$_3$ ·x H$_2$O: Alfa Aesar, 99,9 % (REO), Pulver, Schmelzpunkt: 143°C; Zirkonium(IV)-(2,4)penandionat, Zr[CH$_3$COCH-COCH$_3$]$_4$: Strem Chemicals, ≥ 98 %, kristallin). Die Lösung wurde gemäß der Pufferstöchiometrie auf eine Konzentration von 0,1 M bezogen auf La$_2$Zr$_2$O$_7$ eingestellt. Zur genauen Einstellung der Metallgehalte wurden die Ausgangsstoffe mittels ICP-OES (Inductively coupled plasma-optical emissionspectroscopy) charakterisiert. Als Lösungsmittel für die Lösung wurde Propionsäure (Propionsäure, CH$_3$CH$_2$COOH: Merck, ≥ 99 %, Schmelzpunkt: -21°C, Siedepunkt: 141°C, Flammpunkt: 50°C) verwendet.

Die Beschichtung erfolgte an Substratbändern mit einem Querschnitt von 5 x 0,1 mm$^2$ und einer Länge von 50 m in einer kontinuierlichen Beschichtungsapparatur.

Diese Apparatur besteht aus einer Abspul-, einer Beschichtungs-, einer Trocknungs- und einer Aufwickeleinheit. Das Band wird unter einem Zug von 10 N mit einer Geschwindigkeit von 5 cm/min durch die Anlage gezogen. Die Zugkraft wird dabei so gewählt, dass sie geringer ist als die Streckgrenze des verwendeten Metallbandes. Die Beschichtung erfolgt mit einem Auszugswinkel von 70° bezogen auf die Lösungsoberfläche. Der Auszugswinkel kann in einem Bereich von 20 bis 90° variiert werden, wobei ein geringerer Winkel eine größere Schichtdicke bedeutet. Gleiche Schichtdicken können z.B. mit der Kombination 70° und 5cm/min sowie 90° und 5,8 cm/min erreicht werden. Die Trocknung erfolgt in zwei Schritten. Die Vortrocknung erfolgt unterhalb der Siedetemperatur des Lösungsmittels (Methanol; 65°C) bei Temperaturen von 60°C auf einer Strecke von 50 cm und die Endtrocknung auf einer Strecke von 100 cm bei einer Temperatur von 90°C. Das Band wurde nach der Trocknung auf ein Keramikrohr (Korund) mit einem Durchmesser von 20 cm und einer Länge von 100 cm schraubenförmig (Solenoid) aufgewickelt.

Das Band wurde mit dem Trägerrohr in einen Glühofen überführt und bei der üblichen Temperatur von 850°C bis 1100°C innerhalb von 2 h kristallisiert.

Als zweite Pufferschicht wurde Ceroxid aufgebracht. Die Beschichtungslösung besteht hier aus Ce(III)-acetat gelöst in Propionsäure, 2-Propanol und Acetylaceton (Ce(III)-acetat, Ce(CH$_3$COO)$_3$·xH$_2$O; Sigma-Aldrich Chemie, 99,9 % und Propionsäure, CH$_3$CH$_2$COOH: Merck, ≥ 99%, Schmelzpunkt: -21°C, Siedepunkt: 141°C, Flammpunkt: 50°C und 2-Propanol (Isopropanol), (CH$_3$)$_2$CHOH; Sigma-Aldrich Chemie, 99,5 %, Siedepunklt 82°C und Acetylaceton, CH$_3$COCH$_2$COCH$_3$; Sigma-Aldrich Chemie, > 99%, Siedepunkt 140°C. Die Lösungsmittel hatten das Verhältnis 5 : 2 : 1, wobei in einem weiten Bereich mit Anteilen Propionsäure > 20% variiert werden kann. Die Lösungskonzentration wurde auf 0,25M eingestellt. Die Beschichtungslösung wurde analog zu ersten Beschichtungslösung aufgebracht. Die Kristallisation erfolgte bei den üblichen Temperaturen von 900°C bis 1050°C innerhalb einer Stunde.

Nach Austausch der Puffer-Beschichtungslösung in der kontinuierlichen Beschichtungsanlage gegen eine TFA-YBCO-Beschichtungslösung wurde das erhaltene Band mit einer Geschwindigkeit von 6 cm/min unter ansonsten unveränderten Bedingungen durch die Anlage geführt und wiederum auf ein Keramikträgerrohr aufgespult.

Die YBCO-TFA-Precursorlösung wurde aus Y(III)-acetat-Tetrahydrat (Y(OOCCH3)3·4 H2O: Alfa Aesar, 99,99 % (REO), kristallin), Ba(II)-acetat (Ba(OOCCH3)2 : Alfa Aesar, 99,999 % (metals basis)) und Cu(II)-acetat-Monohydrat (Cu(OOCCH3)2·H2O: Aldrich, ≥ 99,99 %, kristallin) unter Verwendung von Trifluoressigsäure (CF3COOH: Merck, zur Synthese, > 99 %, Schmelzpunkt: -15°C, Siedepunkt: 72°C, umweltgefährlich!) und Methanol (CH3OH: Merck, zur Analyse, > 99,8 %, Schmelzpunkt: -98°C, Siedepunkt: 64,5°C, Flammpunkt: 11°C, giftig!) als Lösungsmittel hergestellt. Die Konzentration betrug 0,1M bezüglich Y. Die Zusammensetzungen der Lösungen wurden gemäß Y : Ba : Cu = 1 : 2 : 3 eingestellt:

Die aufgetragene Schicht wurde anschließend auf dem Keramikträgerrohr bei 600°C unter Luft pyrolysiert. Die Temperatur muss mindestens 550°C betragen.

Nach erneutem Austausch der Beschichtungslösung gegen eine Beschichtungssuspension, bestehend aus einer TFA-YBCO-Precursorlösung der Konzentration 0,25M bezüglich Y, mit Zusatz von 3 Gew% Y2O3 Nanopulver der mittleren Korngröße 40 μm erfolgte wiederum ein Durchlauf durch die Anlage mit einer Geschwindigkeit von 0,2 cm/s.

Das Band mit den erhaltenen Schichten wurde auf dem Keramikträgerrohr in feuchter Atmosphäre wärmebehandelt. Die Pyrolyse erfolgte bei T ≤ 400°C in N$_2$ / 2,5% O$_2$ - Atmosphäre. Die Kristallisation wurde unter einer Atmosphäre von N$_2$ / 100 ppm O$_2$ bei Maximaltemperaturen von 780 bis 790°C und mit einer Haltezeit zwischen einer halben und einer Stunde durchgeführt. Die Maximaltemperatur liegt dabei immer unterhalb der Schmelztemperatur des YBCO. Die Schmelztemperatur wiederum ist von der Sauerstoffkonzentration der Ofenatmosphäre abhängig. Bei höheren Sauerstoffgehalten bis zu 1% ist die Schmelztemperatur um ca. 10° erhöht, bei sauerstofffreier Atmosphäre um ca. 5° erniedrigt. Die Abkühlung der Proben erfolgte in O$_2$ Atmosphäre mit einer Haltezeit von 2 Stunden bei einer Temperatur zwischen 500 und 400°C. Typische Ergebnisse sind:

**Probe 4, gepuffertes Metallsubstrat:**

$$T_{C50} = 89,5 \text{ K}, \quad \Delta T_C = 1,5 \text{ K}, \quad J_C(\text{resistiv}) = 0,9 \text{ MA/cm}^2$$

Schichtdicke 1 (ohne Nanopartikel): ≈ 190 nm
Schichtdicke 2 (mit Nanopartikeln): ≈ 510 nm

$$Jc(5T)/Jc(0T) = 2,5$$

**Patentansprüche**

1. Naßchemisches Verfahren zur Herstellung eines bandförmigen HTSL mit Pinningzentren, mit den Schritten:

 (a) Aufbringen einer Precursorlösung auf einen Träger,
 (b) Trocknen der Precursorlösung, und
 (c) Glühbehandlung,

 wobei mindestens die Schritte (a) und (b) i-mal wiederholt werden, und i eine natürliche Zahl größer 0 ist, **dadurch gekennzeichnet, dass**
 die in Schritt (a) aufgebrachte Precursorlösung eine Konzentration $c_0$ mit $c_0 > 0$ an Pinningzentren hat, die kleiner ist als die Konzentration $c_1$ an Pinningzentren der bei der ersten Wiederholung von Schritt (a) aufgebrachten Precursorlösung ($0 < c_0 < c_1$).

2. Naßchemisches Verfahren zur Herstellung eines bandförmigen HTSL mit Pinningzentren, mit den Schritten:

 (a) Aufbringen einer HTSL-Precursorlösung auf einen-Träger,
 (b) Trocknen der Lösung, und
 (c) Glühbehandlung,

 wobei mindestens die Schritte (a) und (b) i-mal wiederholt werden, und i eine natürliche Zahl größer 0 ist, **dadurch gekennzeichnet, dass** die in Schritt (a) aufgebrachte Precursorlösung eine Konzentration $c_0$ an Pinningzentren hat, die kleiner ist als die Konzentration $c_1$ an Pinningzentren der bei der ersten Wiederholung von Schritt (a) aufgebrachten Precursorlösung ($0 \leq c_0 < c_1$), und dass für alle $i > 1$ gilt, dass $0 \leq c_i \leq c_1$, wobei $c_i$ die Konzentration der Pinningzentren der bei der durch den Index bezeichneten Wiederholung von Schritt (a) aufgebrachten Precursorlösung bezeichnet.

3. Naßchemisches Verfahren zur Herstellung eines bandförmigen HTSL mit Pinningzentren, mit den Schritten:

 (a) Aufbringen einer HTSL-Precursorlösung auf einen Träger,
 (b) Trocknen der Precursorlösung, und
 (c) Glühbehandlung,

 wobei mindestens die Schritte (a) und (b) i-mal wiederholt werden, und i eine natürliche Zahl größer 0 ist, **dadurch gekennzeichnet, dass** die in Schritt (a) aufgebrachte Precursorlösung eine Konzentration $c_0$ an Pinningzentren hat, die kleiner ist, als die Konzentration $c_1$ an Pinningzentren der bei der ersten Wiederholung von Schritt (a) aufgebrachten Precursorlösung ($0 \leq c_0 < c_1$), und daß $c_i < c_{i+1}$, wobei i eine gerade, natürliche Zahl größer 0 ist und $c_i$ die Konzentration der Pinningzentren bei der durch den Index bezeichneten Wiederholung von Schritt (a) aufgebrachten Precursorlösung bezeichnet.

4. Naßchemisches Verfahren zur Herstellung eines bandförmigen HTSL mit Pinningzentren, mit den Schritten:

 (a) Aufbringen einer HTSL-Precursorlösung auf einen Träger,
 (b) Trocknen der Precursorlösung, und
 (c) Glühbehandlung,

 wobei mindestens die Schritte (a) und (b) i-mal wiederholt werden, und i eine natürliche Zahl größer 0 ist, **dadurch gekennzeichnet, dass** die in Schritt (a) aufgebrachte Precursorlösung eine Konzentration $c_0$ an Pinningzentren hat, die kleiner ist als die Konzentration $c_1$ an Pinningzentren der bei der ersten Wiederholung von Schritt (a) aufgebrachten Precursorlösung ($0 \leq c_0 < c_1$), und dass für Schichten i,j mit $c_i < c_j$ gilt $d_i < d_j$, wobei $d_i$ und $d_j$ die

Schichtdicke der bei der i-ten, bzw. j-ten Wiederholung von Schritt (a) aufgetragenen Schicht sowie $c_i$ und $c_j$ die Konzentration an Pinningzentren der bei der i-ten bzw. j-ten Wiederholung von Schritt (a) aufgetragenen Precursorlösung bezeichnet.

**5.** Naßchemisches Verfahren zur Herstellung eines bandförmigen HTSL mit Pinningzentren, mit den Schritten:

> (a) Aufbringen einer HTSL-Precursorlösung auf einen Träger,
> (b) Trocknen der Precursorlösung, und
> (c) Glühbehandlung,

wobei mindestens die Schritte (a) und (b) i-mal wiederholt werden, und i eine natürliche Zahl größer 0 ist, **dadurch gekennzeichnet, dass** die in Schritt (a) aufgebrachte Precursorlösung eine Konzentration $c_0$ an Pinningzentren hat, die kleiner ist als die Konzentration $c_1$ an Pinningzentren der bei der ersten Wiederholung von Schritt (a) aufgebrachten Precursorlösung ($0 \leq c_0 < c_1$), und dass bei der ersten Wiederholung (i = 1) von Schritt (a) eine dickere Schicht als in Schritt (a) aufgetragen wird.

**6.** Naßchemisches Verfahren zur Herstellung eines bandförmigen HTSL mit Pinningzentren, mit den Schritten:

> (a) Aufbringen einer HTSL-Precursorlösung auf einen Träger,
> (b) Trocknen der Lösung, und
> (c) Glühbehandlung,

wobei mindestens die Schritte (a) und (b) i-mal wiederholt werden, und i eine natürliche Zahl größer 0 ist, **dadurch gekennzeichnet, dass** die in Schritt (a) aufgebrachte Precursorlösung eine Konzentration $c_0$ an Pinningzentren hat, die kleiner ist als die Konzentration $c_1$ an Pinningzentren der bei der ersten Wiederholung von Schritt (a) aufgebrachten Lösung ($0 \leq c_0 < c_1$), und dass zumindest ein Teil der Pinningzentren Zirkonoxid und/oder stabilisiertes Zirkonoxid und/oder Ceroxid und/oder Bariumzirkonat und/oder Lanthanzirkonat und/oder Yttriumoxid und/oder $RE_2Ba_4CaMO_y$ enthält, wobei RE für beliebige Seltenerdmetalle, M für Zr, Nb, Mo, Ru, Hf, Ta, W oder Sn und y für eine rationale Zahl größer Null stehen.

**7.** Naßchemisches Verfahren zur Herstellung eines bandförmigen HTSL mit Pinningzentren, mit den Schritten:

> (a) Aufbringen einer HTSL-Precursorlösung auf einen-Träger,
> (b) Trocknen der Lösung, und
> (c) Glühbehandlung,

wobei mindestens die Schritte (a) und (b) i-mal wiederholt werden, und i eine natürliche Zahl größer 0 ist, **dadurch gekennzeichnet, dass** die in Schritt (a) aufgebrachte Precursorlösung eine Konzentration $c_0$ an Pinningzentren hat, die kleiner ist als die Konzentration $c_1$ an Pinningzentren der bei der ersten Wiederholung von Schritt (a) aufgebrachten Precursorlösung ($0 \leq c_0 < c_1$), und daß als Pinningzentren Nanopartikel mit einer mittleren Korngröße kleiner 110 nm verwendet werden.

**8.** Verfahren nach Anspruch 7, **dadurch gekennzeichnet, dass** die mittlere Korngröße zwischen 2 nm und 80 nm. liegt.

**9.** Verfahren nach Anspruch 7 oder 8, **dadurch gekennzeichnet, dass** die Nanopartikel gegenüber dem HTSL-Material und seinen Edukten zumindest weitgehend inert sind.

**10.** Verfahren nach einem der Ansprüche 7 bis 9, **dadurch gekennzeichnet, dass** die Länge mindestens einer Komponente des Gittervektors der Nanopartikel nicht mehr als etwa 10 % von der Länge einer Komponente des Gittervektors der HTSL-Schicht abweicht.

**11.** Verfahren nach einem der Ansprüche 1 bis 10, wobei $c_0 \leq {}^1/_{10}\, c_1$ gilt.

**Claims**

**1.** A wet-chemical method for producing a strip-like HTSC with pinning centers, with the steps of:

(a) application of a precursor solution onto a carrier;
(b) drying of the precursor solution, and
(c) annealing treatment,

with at least the steps (a) and (b) being repeated i times, and i being a natural number larger than 0, **characterized in that** the precursor solution applied in step (a) has a concentration $c_0$ with $c_0 > 0$ at the pinning centers which is lower than the concentration $c_1$ at the pinning centers of the precursor solution applied during the first repetition of step (a) ($0 < c_0 < c_1$).

2. A wet-chemical method for producing a strip-like HTSC with pinning centers, with the steps of:

(a) application of an HTSC precursor solution to a carrier;
(b) drying of the solution, and
(c) an annealing treatment,

with at least the steps (a) and (b) being repeated i times, and i being a natural number larger than 0, **characterized in that** the precursor solution applied in step (a) has a concentration $c_0$ at the pinning centers which is lower than the concentration $c_1$ at the pinning centers of the precursor solution applied during the first repetition of step (a) ($0 \leq c_0 < c_1$), and i > 1 applies to all, with $0 \leq c_i \leq c_1$, with $c_i$ designating the concentration of the pinning centers of the precursor solution applied in the repetition of step (a) designated by the index.

3. A wet-chemical method for producing a strip-like HTSC with pinning centers, with the steps of:

(a) application of an HTSC precursor solution to a carrier;
(b) drying of the precursor solution, and
(c) an annealing treatment,

with at least the steps (a) and (b) being repeated i times, and i being a natural number larger than 0, **characterized in that** the precursor solution applied in step (a) has a concentration $c_0$ at the pinning centers which is lower than the concentration $c_1$ at the pinning centers of the precursor solution applied during the first repetition of step (a) ($0 \leq c_0 < c_1$), and $c_i < c_{i+1}$, with i being an even natural number larger than 0, and $c_i$ designating the concentration of the pinning centers in the precursor solution applied by the repetition of step (a) designated by the index.

4. A wet-chemical method for producing a strip-like HTSC with pinning centers, with the steps of:

(a) application of an HTSC precursor solution to a carrier;
(b) drying of the precursor solution, and
(c) an annealing treatment,

with at least the steps (a) and (b) being repeated i times, and i being a natural number larger than 0, **characterized in that** the precursor solution applied in step (a) has a concentration $c_0$ at the pinning centers which is lower than the concentration $c_1$ at the pinning centers of the precursor solution applied during the first repetition of step (a) ($0 \leq c_0 < c_1$), and $d_i < d_j$ applies to layers i, j with $c_i < c_j$, with $d_i$ and $d_j$ designating the layer thickness of the layer applied during the $i^{th}$ and $j^{th}$ repetition of step (a), and $c_i$ and $c_j$ designating the concentration at pinning centers of the precursor solution applied during the the $i^{th}$ and $j^{th}$ repetition of step (a).

5. A wet-chemical method for producing a strip-like HTSC with pinning centers, with the steps of:

(a) application of an HTSC precursor solution to a carrier;
(b) drying of the precursor solution, and
(c) an annealing treatment,

with at least the steps (a) and (b) being repeated i times, and i being a natural number larger than 0, **characterized in that** the precursor solution applied in step (a) has a concentration $c_0$ at the pinning centers which is lower than the concentration $c_1$ at the pinning centers of the precursor solution applied during the first repetition of step (a) ($0 \leq c_0 < c_1$), and a thicker layer than in step (a) is applied in the first repetition (i=1) of step (a).

6. A wet-chemical method for producing a strip-like HTSC with pinning centers, with the steps of:

EP 1 850 402 B1

(a) application of an HTSC precursor solution to a carrier;
(b) drying of the solution, and
(c) an annealing treatment,

with at least the steps (a) and (b) being repeated i times, and i being a natural number larger than 0, **characterized in that** the precursor solution applied in step (a) has a concentration $c_0$ at the pinning centers which is lower than the concentration $c_1$ at the pinning centers of the precursor solution applied during the first repetition of step (a) ($0 \leq c_0 < c_1$), and that at least a part of the pinning centers contains zirconium oxide and/or stabilized zirconium oxide and/or cerium oxide and/or barium zirconate and/or lanthanum zirconate and/or yttrium oxide and/or $RE_2Ba_4CaMo_y$, with RE standing for random rare earth metals, M for Zr, Nb, Mo, Ru, Hf, Ta, W or Sn, and y for a rational number larger than zero.

7. A wet-chemical method for producing a strip-like HTSC with pinning centers, with the steps of:

   (a) application of an HTSC precursor solution to a carrier;
   (b) drying of the solution, and
   (c) an annealing treatment,

   with at least the steps (a) and (b) being repeated i times, and i being a natural number larger than 0, **characterized in that** the precursor solution applied in step (a) has a concentration $c_0$ at the pinning centers which is lower than the concentration $c_1$ at the pinning centers of the precursor solution applied during the first repetition of step (a) ($0 \leq c_0 < c_1$), and nanoparticles with a mean grain size of less than 110 nm are used.

8. A method according to claim 7, **characterized in that** the mean grain size is between 2 nm and 80 nm.

9. A method according to claim 7 or 8, **characterized in that** the nanoparticles are substantially inert towards the HTSC material and its educts.

10. A method according to one of the claims 7 to 9, **characterized in that** the length of at least one component of the lattice vector of the nanoparticles deviates by not more than 10% from the length of a component of the lattice vector of the HTSC layer.

11. A method according to one of the claims 1 to 10, wherein $c_0 \leq 1/10\ c_1$ applies.

**Revendications**

1. Procédé de traitement au mouillé destiné à la réalisation d'un supraconducteur à haute température en forme de ruban avec des centres d'ancrage, du type comprenant les étapes consistant à :

   (a) appliquer un précurseur en solution sur un support,
   (b) sécher le précurseur en solution et
   (c) traitement de recuit,

   les étapes (a) et (b) au moins étant répétées i fois et i étant un entier naturel supérieur à 0, **caractérisé en ce que** le précurseur en solution appliqué à l'étape (a) a une concentration en centres d'ancrage $c_0$ où $c_0 > 0$ qui est inférieure à la concentration en centres d'ancrage $c_1$ du précurseur en solution ($0 < c_0 < c_1$) appliqué alors que l'on répète une première fois l'étape (a).

2. Procédé de traitement au mouillé destiné à la réalisation d'un supraconducteur à haute température en forme de ruban avec des centres d'ancrage, du type comprenant les étapes consistant à :

   (a) appliquer sur un support un précurseur en solution pour supraconducteurs à haute température,
   (b) sécher la solution et
   (c) traitement de recuit,

   les étapes (a) et (b) au moins étant répétées i fois et i étant un entier naturel supérieur à 0, **caractérisé en ce que** le précurseur en solution appliqué dans l'étape (a) a une concentration en centres d'ancrage $c_0$ qui est inférieure à la concentration en centres d'ancrage $c_1$ du précurseur en solution ($0 < c_0 < c_1$) appliqué lorsque l'on répète une première fois l'étape (a) et que pour tous les i > 1 il vaut que $0 \leq c_i \leq c_1$, $c_i$ désignant la concentration en centres d'ancrage du précurseur en solution appliqué lorsque l'on répète l'étape (a) pour la fois indiquée par l'index.

3. Procédé de traitement au mouillé destiné à la réalisation d'un supraconducteur à haute température en forme de ruban avec des centres d'ancrage, du type comprenant les étapes consistant à :

   (a) appliquer sur un support un précurseur en solution pour supraconducteurs à haute température,
   (b) sécher le précurseur en solution et
   (c) traitement de recuit,

les étapes (a) et (b) au moins étant répétées i fois et i étant un entier naturel supérieur à 0, **caractérisé en ce que** le précurseur en solution appliqué dans l'étape (a) a une concentration en centres d'ancrage $c_0$ qui est inférieure à la concentration en centres d'ancrage $c_1$ du précurseur en solution ($0 < c_0 < c_1$) appliqué lorsque l'on répète une première fois l'étape (a) et que $c_i < c_{i+1}$, i étant un entier naturel pair supérieur à 0 et $c_i$ désignant la concentration en centres d'ancrage du précurseur en solution appliqué lorsque l'on répète l'étape (a) pour la fois indiquée par l'index.

4. Procédé de traitement au mouillé destiné à la réalisation d'un supraconducteur à haute température en forme de ruban avec des centres d'ancrage, du type comprenant les étapes consistant à :

   (a) appliquer sur un support un précurseur en solution pour supraconducteurs à haute température,
   (b) sécher le précurseur en solution et
   (c) traitement de recuit,

les étapes (a) et (b) au moins étant répétées i fois et i étant un entier naturel supérieur à 0, **caractérisé en ce que** le précurseur en solution appliqué dans l'étape (a) a une concentration en centres d'ancrage $c_0$ qui est inférieure à la concentration en centres d'ancrage $c_1$ du précurseur en solution ($0 < c_0 < c_1$) appliqué lorsque l'on répète une première fois l'étape (a) et que pour les couches i, j où $c_i < c_j$ il vaut que $d_i < d_j$, $d_i$ et $d_j$ désignant l'épaisseur de la couche appliquée lors de la i$^{\text{ième}}$ ou de la j$^{\text{ième}}$ répétition de l'étape (a) et $c_i$ et $c_j$ désignant la concentration en centres d'ancrage du précurseur en solution appliqué lors de la i$^{\text{ième}}$ ou j$^{\text{ième}}$ répétition de l'étape (a).

5. Procédé de traitement au mouillé destiné à la réalisation d'un supraconducteur à haute température en forme de ruban avec des centres d'ancrage, du type comprenant les étapes consistant à :

   (a) appliquer sur un support un précurseur en solution pour supraconducteurs à haute température,
   (b) sécher le précurseur en solution et
   (c) traitement de recuit,

les étapes (a) et (b) au moins étant répétées i fois et i étant un entier naturel supérieur à 0, **caractérisé en ce que** le précurseur en solution appliqué dans l'étape (a) a une concentration en centres d'ancrage $c_0$ qui est inférieure à la concentration en centres d'ancrage $c_1$ du précurseur en solution ($0 < c_0 < c_1$) appliqué lorsque l'on répète une première fois l'étape (a) et que, lors de la première répétition (i = 1) de l'étape (a), on applique une couche plus épaisse qu'à l'étape (a).

6. Procédé de traitement au mouillé destiné à la réalisation d'un supraconducteur à haute température en forme de ruban avec des centres d'ancrage, du type comprenant les étapes consistant à :

   (a) appliquer sur un support un précurseur en solution pour supraconducteurs à haute température,
   (b) sécher le précurseur en solution et
   (c) traitement de recuit,

les étapes (a) et (b) au moins étant répétées i fois et i étant un entier naturel supérieur à 0, **caractérisé en ce que** le précurseur en solution appliqué dans l'étape (a) a une concentration en centres d'ancrage $c_0$ qui est inférieure à la concentration en centres d'ancrage $c_1$ du précurseur en solution ($0 < c_0 < c_1$) appliqué lorsque l'on répète une première fois l'étape (a) et qu'au moins une partie des centres d'ancrage contient de l'oxyde de zirconium et/ou de l'oxyde de zirconium stabilisé et/ou de l'oxyde de cérium et/ou du zirconate de baryum et/ou du zirconate de lanthane et/ou de l'oxyde d'yttrium, et/ou $RE_2Ba_4CaMO_y$, RE désignant toute terre rare, M désignant Zr, Nb, Mo, Ru, Hf, Ta, W ou Sn et y étant un nombre rationnel supérieur à zéro.

**7.** Procédé de traitement au mouillé destiné à la réalisation d'un supraconducteur à haute température en forme de ruban avec des centres d'ancrage, du type comprenant les étapes consistant à :

(a) appliquer sur un support un précurseur en solution pour supraconducteurs à haute température,
(b) sécher le précurseur en solution et
(c) traitement de recuit,

les étapes (a) et (b) au moins étant répétées i fois et i étant un entier naturel supérieur à 0, **caractérisé en ce que** le précurseur en solution appliqué dans l'étape (a) a une concentration en centres d'ancrage $c_0$ qui est inférieure à la concentration en centres d'ancrage $c_1$ du précurseur en solution ($0 < c_0 < c_1$) appliqué lorsque l'on répète une première fois l'étape (a) et que l'on utilise comme centres d'ancrage des nanoparticules d'une granulométrie moyenne inférieure à 110 nm.

**8.** Procédé selon la revendication 7, **caractérisé en ce que** la granulométrie moyenne est comprise entre 2 nm et 80 nm.

**9.** Procédé selon la revendication 7 ou 8, **caractérisé en ce que,** comparé au matériau de supraconducteurs à haute température et à ses produits de départ, les nanoparticules sont du moins en grande partie inertes.

**10.** Procédé selon l'une quelconque des revendications 7 à 9, **caractérisé en ce que** la longueur d'au moins un composant du vecteur du réseau des nanoparticules ne diffère pas de plus que d'environ 10 % de la longueur d'un composant du vecteur du réseau de la couche du supraconducteur à haute température.

**11.** Procédé selon l'une quelconque des revendications 1 à 10 où $c_0 \leq 1/10\, c_1$.

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20050159298 A1
- WO 2006137898 A2